# EUROPÄISCHE PATENTANMELDUNG

(11) **EP 3 736 853 A1**
(43) Veröffentlichungstag der Anmeldung: **11.11.2020**
(21) Anmeldenummer: 20171089.4
(22) Anmeldetag: 23.04.2020
(51) Int. Cl.: H01L 21/60, H01L 23/492, H01L 23/495

(54) **KONTAKTANORDNUNG UND LEISTUNGSMODUL**

(30) Priorität: 10.05.2019 DE 102019206824
(71) Anmelder: Robert Bosch GmbH, 70442 Stuttgart (DE)
(72) Erfinder: Suenner, Thomas, 67435 Neustadt (DE); Sueske, Erik, 72764 Reutlingen (DE); Zipprich, Juergen, 72127 Kusterdingen (DE); Schiele, Christian, 1103 Budapest (HU); Krutsch, Andreas, 72108 Rottenburg (DE)

(57) **Zusammenfassung**

Ausgegangen wird von einer Kontaktanordnung mit einem elektrischen und/oder thermischen Anschlusselement, wobei das Anschlusselement zumindest einen Verbindungsbereich mit einem ersten Fügepartner (10) aufweist, welcher mit dem Anschlusselement mittels eines verfestigten Verbindungsmittels stoffverbunden ist. Dabei stellt sich eine Lageposition des Anschlusselementes relativ zum ersten Fügepartner (10) zumindest in einer Raumrichtung, insbesondere in allen drei Raumrichtungen, toleranzbehaftet mit einem Verfestigen des Verbindungsmittels ein, beispielsweise durch einen Setzvorgang infolge der Ausbildung des Stoffschlusses. Das Anschlusselement ist nun aus zumindest einem ersten (30.1) und einem zweiten (30.2) Teilelement gebildet und das erste (30.1) und das zweite (30.2) Teilelement sind dabei durch einen Spalt voneinander beabstandet, wobei das erste (30.1) Teilelemente den Verbindungsbereich umfasst. Ferner ist der Spalt durch ein Verbindungselement (30.3) überbrückt, welches zum Ausgleich eines Lagepositionsversatzes zwischen dem ersten (30.1) und dem zweiten (30.2) Teilelement in der zumindest toleranzbehafteten Raumrichtung mittels des gleichen oder mittels eines anderen verfestigten Verbindungsmittels jeweils mit dem ersten (30.1) und mit dem zweiten (30.2) Teilelement stoffverbunden ist.

## Beschreibung

Die Erfindung betrifft eine Kontaktanordnung, ein die Kontaktanordnung umfassendes Leistungsmodul sowie ein Verfahren zur Ausbildung der Kontaktanordnung gemäß dem Oberbegriff der unabhängigen Ansprüche.

### Stand der Technik

Elektrische und/oder elektronische Bauelemente werden in vielen Elektronikausführungen durch einen Reflow-Lötprozess thermisch und elektrisch mit beispielsweise einem Schaltungsträger unter Ausbildung einer elektronischen Schaltung verbunden. Um komplexe Aufbauten mit mehreren Bauelementen und Lötstellen kostengünstig herstellen zu können, werden sämtliche Verbindungsstellen bevorzugt in einem Schritt gelötet.

Bei Powermodulen in der Leistungselektronik werden elektrische Ströme beispielsweise über massive Cu-Stanzgitterelemente geleitet, welche auch einen Außenanschluss der Module mit ausbilden. Eine Umkontaktierung auf Leistungshalbleiter erfolgt beispielsweise durch eine Lötverbindung. Alternativ kann ein Außenanschluss auch durch eine Schweiß- oder Schraubverbindung gestellt werden, Das Weichlöten als Umkontaktierung der Stanzgitter ist nur möglich, wenn die entsprechenden Toleranzanforderungen an die Lagegenauigkeit der Fügepartner eingehalten werden. Durch den Lötvorgang kommt es beim Verfestigen des Lotmittels oft zu Setzvorgängen, durch welche eine Verbindungskontaktierung mechanisch überbestimmt wird. Dies schränkt die Aufbau- und Verbindungstechnik stark ein oder macht diese unmöglich.

### Offenbarung der Erfindung

### Vorteile

Der Erfindung liegt die Aufgabe zu Grunde, Kontaktanordnungen mit stofflich verbundenen Fügepartnern trotz Setzvorgängen infolge der Ausbildung eines Stoffschlusses prozesssicher bereitzustellen.

Diese Aufgabe wird durch eine Kontaktanordnung, ein die Kontaktanordnung umfassendes Leistungsmodul sowie ein Verfahren zur Ausbildung der Kontaktanordnung gemäß den unabhängigen Ansprüchen gelöst.

Ausgegangen wird von einer Kontaktanordnung mit einem elektrischen und/oder thermischen Anschlusselement, wobei das Anschlusselement zumindest einen Verbindungsbereich mit einem ersten Fügepartner aufweist, welcher mit dem Anschlusselement mittels eines verfestigten Verbindungsmittels stoffverbunden ist. Dabei stellt sich eine Lageposition des Anschlusselementes relativ zum ersten Fügepartner zumindest in einer Raumrichtung, insbesondere in allen drei Raumrichtungen, toleranzbehaftet mit einem Verfestigen des Verbindungsmittels ein, beispielsweise durch einen Setzvorgang infolge der Ausbildung des Stoffschlusses. Das Anschlusselement ist nun aus zumindest einem ersten und einem zweiten Teilelement gebildet und das erste und das zweite Teilelement sind dabei durch einen Spalt voneinander beabstandet, wobei das erste Teilelemente den Verbindungsbereich umfasst. Ferner ist der Spalt durch ein Verbindungselement überbrückt, welches zum Ausgleich eines Lagepositionsversatzes zwischen dem ersten und dem zweiten Teilelement in der zumindest toleranzbehafteten Raumrichtung mittels des gleichen oder mittels eines anderen verfestigten Verbindungsmittels jeweils mit dem ersten und mit dem zweiten Teilelement stoffverbunden ist. Das Verbindungselement weist den großen Vorteil auf, dass es einer Bewegung des ersten Teilelementes - und somit einer Lagerveränderung gegenüber einer ursprünglichen Anordnung - während der Ausbildung des Stoffschlusses nachfolgt. Die Bewegung kann beispielsweise resultieren aufgrund eines Setzvorganges durch die Ausbildung eines Stoffschlusses zwischen dem ersten Teilelement und dem ersten Fügepartner. Das Setzen kann hierbei vom ersten Teilelement und/oder vom ersten Fügepartner ausgehen. Ferner kann auch ein Setzvorgang weiterer Fügepartner mit enthalten sein, die mit dem ersten Teilelement und/oder dem ersten Fügepartner stoffverbunden sind. Ebenso ist es zusätzlich ermöglicht, dass das Verbindungselement in gleicher Weise einer Bewegung des zweiten Teilelementes folgt, insbesondere, wenn dieses oder mit diesem stoffverbundene weitere Fügepartner ebenso durch einen Setzvorgang infolge der Ausbildung eines Stoffschlusses in seiner/deren Lage im Vergleich zu einer ursprünglichen Anordnung verändert wird/werden. Insgesamt ist mittels des Verbindungselementes vorteilhaft bewirkt, dass die Ausbildung der Kontaktanordnung insgesamt unter mechanisch bestimmten Bedingungen erfolgen kann.

In einer vorteilhaften Ausführungsform der Kontaktanordnung ist der erste Fügepartner auf einer dem ersten Teilelement abgewandten Seite mit einem zweiten Fügepartner mittels des verfestigten Verbindungsmittels stoffverbunden. Der zweite Fügepartner ist dabei insbesondere ein Schaltungsträger, beispielsweise ein DBC (direct bonded copper), ein IMS (insulated metal substrat), ein AMB (activ metal brazing), ein LTCC (low temperature cofired ceramic) oder eine FR4-Leiterplatte. Insbesondere lassen sich dadurch viele unterschiedliche Elektronikausführungen abdecken, die in einem Stapelaufbau auf einem Trägersubstrat stoffverbundene Fügepartner als Kontaktanordnung vorsehen. Es sind anwendungsspezifisch auch andere Schaltungsträgertypen denkbar.

In einer weiteren vorteilhaften Ausführungsform der Kontaktanordnung weist das zweite Teilelement einen zweiten Verbindungsbereich zu einem dritten Fügepartner aufweist. Dieser ist insbesondere ein Abstandshalter, mittels welchem das zweite Teilelement in einem Abstand zu einem Grundelement gehalten wird. Das Grundelement kann beispielsweise der zweite Fügepartner sein, beispielsweise ein Schaltungsträger. Ebenso kann der dritte Fügepartner ein elektrisches und/oder elektronisches Bauelement sein, beispielsweise ein Leistungshalbleiter oder ein Logikchip, welcher wiederrum auf dem genannten Schaltungsträger angeordnet ist. Der dritte Fügepartner ist dabei mit dem zweiten Teilelement und bevorzugt mit dem zweiten Fügepartner jeweils mittels des gleichen oder mittels eines anderen Verbindungsmittels stoffverbunden, wobei eine Lageposition des zweiten Teilelementes relativ zum ersten und/oder zweiten und/oder dritten Fügepartner zumindest in der toleranzbehafteten Raumrichtung mit einem Verfestigen des Verbindungsmittels eingestellt ist. Insgesamt lassen sich auf diese Weise die Möglichkeiten an Elektronikausführungen erweitern, die ein Komplex von miteinander Stoffverbundenen Elementen enthalten.

Für viele Anwendungen zeigt sich eine günstige Ausführungsform der Kontaktanordnung darin, dass das Verbindungsmittel ein aus einem geschmolzen Zustand verfestigtes Lotmittel ist. Insbesondere ist dabei das Vorsehen eines Reflowlötens vorteilhaft, wodurch in einem sehr effizienten Lötprozess eine Vielzahl von lotverbundenen Verbindungsbereichen ausbildbar sind.

In einer alternativen Ausführungsform der Kontaktanordnung weist das zweite Teilelement in zumindest einem Fixbereich einen fest definierten Abstand in der zumindest toleranzbehafteten Raumrichtung zu dem zweiten Fügepartner auf. So ist beispielsweise der zweite Fügepartner der Schaltungsträger, wodurch dem zweiten Teilelement ein definierter Ortsbezug innerhalb einer Elektronikbaugruppe, umfassend die Kontaktanordnung, zugeordnet werden kann. Dies ist insbesondere vorteilhaft bei einem Anschlusskontakt, welcher durch das zweite Teilelement oder zumindest das zweite Teilelement enthaltend ausgebildet ist. Ein so vorliegender Anschlusskontakt kann dann als Kontaktschnittstelle für einen Gegenkontakt genutzt werden.

In einer allgemeinen Weiterbildung der Kontaktanordnung ist das erste Teilelement zwischen dem Verbindungsbereich mit dem ersten Fügepartner und dem Stoffschluss mit dem Verbindungselement und/oder ist das zweite Teilelement zwischen dem zweiten Verbindungsbereich oder dem Fixbereich und dem Stoffschluss mit dem Verbindungselement freitragend ausgebildet. Dies bedeutet, dass keine weiteren Stützstellen oder mechanisch festgelegte Bindungsstellen vorliegen, so dass eine Anpassung an eine geänderte Lageposition der beiden Teilelemente ohne Behinderung erfolgen kann.

Besondere Vorteile zeigen sich bei einer Ausführungsform der Kontaktanordnung, bei welcher der erste Fügepartner ein elektrisches und/oder elektronisches Bauelement ist, insbesondere ein Leistungshalbleiterelement oder ein Chipelement. Auf diese Weise kann die Kontaktanordnung einfach für Leistungsmodule oder Ansteuerelektronikbaugruppen zur Anwendung kommen, die eine vertikale Kontaktierung des elektrischen und/oder elektronischen Bauelements vorsehen. Alternativ ist der erste Fügepartner eine Wärmesenke, insbesondere ein Metallelement oder ein unbestücktes Keramiksubstratelement. Somit ist ermöglicht über unterschiedliche Ebenen hinweg einen Wärmepfad bereitzustellen. Im Falle eines Keramiksubstratelementes ist dabei noch sichergestellt, dass eine elektrische Isolierung einen zusätzlichen Strompfad ausschließt.

Eine besonders günstige Ausführungsform der Kontaktanordnung zeigt sich darin, dass das erste Teilelement ein Metallclip ist, welcher ein elektrisches und/oder elektronisches Bauelement mit zumindest einem weiteren elektrischen und/oder elektronischen Bauelement verbindet. Bei einer bevorzugten Ausführung sind mittels des Metallclips insbesondere mindestens zwei Leistungshalbleiter als Teil einer Halbbrücke oder einer B6-Brücke miteinander verbunden.

Dabei ist in einer besonders vorteilhaften Weiterbildung der Kontaktanordnung das zweite Teilelement ein Außenstromanschluss, insbesondere als Teil einer B2- oder B6-Brücke.

Die Erfindung führt auch zu einem Leistungsmodul mit insbesondere einem Außenstromanschluss, welcher als Teil einer Kontaktanordnung nach zumindest einer der zuvor beschriebenen Ausführungsformen mit einer Leistungsschaltung, insbesondere einer B2- oder B6-Brücke, ausgebildet ist.

Die Erfindung führt ferner zu einem Verfahren zur Ausbildung einer Kontaktanordnung nach zumindest einer der zuvor beschriebenen Ausführungsformen, mit den nachfolgenden Verfahrensschritten:
a) Ausbilden einer Fügeanordnung, umfassend zumindest den ersten Fügepartner und das erste Teilelement, wobei in einem vorgesehenen ersten Verbindungsbereich zwischen dem ersten Fügepartner und dem ersten Teilelement zu diesen angrenzend ein Lotdepot angeordnet wird, sowie umfassend zumindest das zweite Teilelement, welches mit einem Spalt beabstandet zum ersten Teilelement angeordnet wird, und umfassend das Verbindungselement, welches gegenüber dem ersten und dem zweiten Teilelement derart angeordnet wird, dass der Spalt durch dieses überbrückt wird, wobei zwischen dem Verbindungselement und den beiden Teilelementen zumindest in einem jeweiligen Bereich zu diesen angrenzend ein Lotdepot angeordnet wird,
b) Temperaturbehandlung der Fügeanordnung, durch welche das Lotdepot als ein in einen geschmolzenen Zustand gebrachtes Lotmittel vorliegt,
c) Verfestigen des Lotmittels durch eine Temperaturabkühlung unter Ausbildung der Kontaktanordnung mit einem jeweiligen Stoffschluss im Bereich eines ursprünglich angeordneten Lotdepots, wobei ein Lagepositionsversatz zwischen dem ersten und dem zweiten Teilelement aufgrund zumindest eines Absetzens des ersten Teilelementes durch den erfolgten Lötvorgang durch das mit beiden Teilelementen stoffverbundene Verbindungselement ausgeglichen wird.

Vorteilhaft ist die Ausbildung einer Kontaktanordnung ermöglicht, bei welcher trotz Setzvorgängen beteiligter Elemente aufgrund des Lötvorganges eine mechanische Bestimmtheit der Anordnung während der Ausbildung der festen Lötverbindung erhalten bleibt. Insbesondere ist der Einsatz eines Reflowlötens ermöglicht, bei welchem mehrere zu verlötende Elemente zeitgleich durch die ausgebildete Lötverbindung in der Kontaktanordnung festgehalten sind. Insbesondere ist ausgeschlossen, dass durch Setzvorgänge unvorteilhafte Spalte zwischen den zu verlötenden Elementen entstehen, da die Lagepositionsveränderungen durch das Mitbewegen des Verbindungselementes nachgeführt wird. Grundsätzlich ist die Beabstandung zweier verlöteten Elemente im Bereich der festen Lötverbindung - und damit die ausgebildete Schicht aus dem verfestigten Lotmittel - durch zusätzliche Abstandshalter zwischen den Elementen festlegbar. Das Lotdepot kann beispielsweise in Form einer Lotpaste oder einer Lotfolie bereitgestellt werden.

In einer Weiterbildung des Verfahrens wird das zweite Teilelement vor der Temperaturbehandlung gemäß dem Verfahrensschritt b) in seiner Lageposition festgehalten, insbesondere durch eine Fügehaltevorrichtung. Dadurch ist dessen Ortsbezug auch nach dem Lötvorgang unverändert gegenüber dem vor dem Lötvorgang. Vorteilhaft kann das zweite Teilelement beispielsweise als ein Außenanschlusselement einer Elektronikbaugruppe, insbesondere eines zuvor beschriebenen Leistungsmoduls, genutzt werden, welches dann durch ein Gegenanschlusselement definiert und immer gleich elektrisch kontaktierbar ist.

### Kurze Beschreibung der Zeichnungen

Weitere Vorteile, Merkmale und Einzelheiten der Erfindung ergeben sich aus der nachfolgenden Beschreibung bevorzugter Ausführungsbeispiele sowie anhand der Zeichnung. Diese zeigt in:

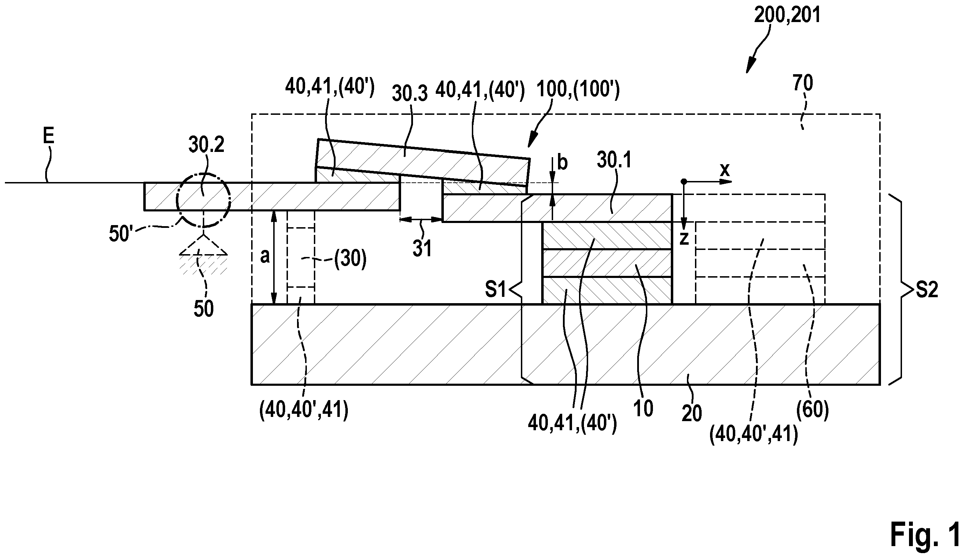

- Fig. 1:: ein Ausführungsbeispiel einer Kontaktanordnung, beispielhaft als Teil eines Leistungsmodules in einer seitlichen Schnittdarstellung.

### Ausführungsformen der Erfindung

Die Fig. 1 zeigt ein Ausführungsbeispiel einer Kontaktanordnung 100. Die Kontaktanordnung 100 ist beispielsweise Teil eines Leistungsmodules 200. Alternativ ist es Teil einer anderen Elektronikbaugruppe. Hierbei ist auf einem Grundelement 20, insbesondere einem Schaltungsträger, ein Stapelaufbau S1 von mehreren verlöteten Fügepartnern 10, 20, 30.1 ausgebildet. So ist ein erster Fügepartner 10 in einem Verbindungsbereich 41 mittels einer Schicht aus einem verfestigten Lotmittel 40 mit dem Grundelement als einem zweiten Fügepartner 20 stofflich verbunden. So ist der erste Fügepartner 10 zum Beispiel ein Leistungshalbleiter mit einem unterseitigen und oberseitigen elektrischen Kontaktanschluss. Ferner weist der erste Fügepartner 10 auf einer dem Schaltungsträger abgewandten Seite, insbesondere dann im Bereich des oberseitigen Kontaktanschlusses eines Leistungshalbleiters, einen weiteren Verbindungbereich 41 auf, in welchem ein erstes Teilelement 30.1 mit dem Leistungshalbleiter 10 mittels einer Schicht des verfestigten Lotmittels 40 stoffverbunden ist. Der Stapelaufbau S1 dabei Teil einer elektronischen Schaltung 201 des Leistungsmodules 200. Das Leistungsmodul 200 umfasst auch einen Außenstromanschluss, welcher mittelbar über den Stapelaufbau S1 mit der elektronischen Schaltung 201 elektrisch kontaktiert ist. Dabei ist der Außenstromanschluss als ein zweites Teilelement 30.2 ausgebildet, welches durch einen Spalt 31 von dem ersten Teilelement 30.1 beabstandet ist. Die beiden Teilelemente 30.1, 30.2 sind dabei mittels eines Verbindungselementes 30.3 stofflich miteinander verbunden. So sind zwischen den jeweiligen Enden des Verbindungselementes 30.1 und einem jeweiligen Ende der Teilelemente 30.1, 30.2 mittels des verfestigten Lotmittels 40 weitere Verbindungsbereiche 41 ausgebildet. Das Verbindungselement 30.3 und die beiden Teilelemente 30.1, 30.2 sind beispielsweise als Metallclips ausgebildet, die bevorzugt im jeweiligen Verbindungsbereich 41 eine ebene und lötbare Oberfläche aufweisen, beispielsweise ein Cu-Metallclip. In einer Fügeanordnung 100' vor einem erfolgten Lötprozess werden bereits der Stapelaufbau S1 sowie das zweite Teilelement 30.2 sowie das Verbindungselement 30.3 derart bereitgestellt, dass in den vorgesehenen Verbindungsbereichen 41 ein Lotdepot 40', beispielsweise in Form einer Lotpaste oder einer Lotfolie, zwischen den zu verlötenden Elementen 10, 20, 30, 30.1, 30.2, 30.2 angeordnet wird. Bevorzugt werden dabei die beiden Teilelemente 30.1, 30.2 in einer gleichen Ebene und weiter bevorzugt zueinander fluchtend ausgerichtet. Insbesondere wird dabei das zweite Teilelement 30.2 als Außenstromanschluss mit einer definierten Ortsposition relativ zum Leistungsmodul 200, beispielsweise mit einem senkrechten Abstand a zwischen einem Fixbereich 50' und dem Schaltungsträger 20, mittels einer Fügehaltevorrichtung 50 ortsfest gehalten. Anschließend wird die so vorliegende Fügeanordnung 100' einer Temperaturbehandlung unterzogen, insbesondere im Rahmen eines Reflowlötprozesses, bei welcher dann alle Lötdepots 40' als Lötmittel 40 im geschmolzenen Zustand vorliegen. Bereits hier kann es zu einem Setzungsvorgang des ersten Teilelementes 30.1 und/oder des ersten Fügepartners 10 kommen. Ein solcher Setzungsvorgang kann auch erst oder zusätzlich im Zuge der Verfestigung des Lotmittels 40 infolge einer Temperaturabkühlung erfolgen, durch welche in allen Verbindungsbereichen 41 eine Lötverbindung als Stoffschluss ausgebildet wird. Aufgrund des Setzungsvorganges bildet sich möglicherweise ein Lagepositionsversatz des ersten Teilelementes 30.1 relativ zum ortsfesten zweiten Teilelement 30.2 in zumindest einer Raumrichtung aus, beispielsweise als Versatz b in der dargestellten z-Richtung, welche senkrecht zur Schaltungsträgeroberfläche orientiert ist. Bis zur Verfestigung des Lotmittels 40 kann das Verbindungselement 30.3 der erfolgten Bewegung aufgrund des Setzungsvorganges nachgehen, wodurch in Abhängigkeit der Größe des Versatzes b eine Schräganordnung des Verbindungselementes 30.3 erfolgt. Dabei ist bevorzugt das erste Teilelement 30.1 zwischen dessen Verbindungsbereich 41 mit dem ersten Fügepartner 10 und dem Verbindungsbereich 41 mit dem Verbindungselement 30.3 und/oder das zweite Teilelement 30.2 zwischen dessen Fixbereich 50' und dem Verbindungsbereich 41 mit dem Verbindungselement 30.3 freitragend ausgebildet. Die Fügehaltevorrichtung 50 kann nach einer Verfestigung des Lotmittels 40 entfernt werden, außer es verbleibt als Teil des Leistungsmodules 200.

Grundsätzlich ist es möglich, dass über das erste Teilelement 30.1 als Metallclip zumindest noch ein weiteres elektrisches und/oder elektronisches Bauelement 60 (gestrichelt dargestellt) stoffverbunden ist. Dabei sind dann das weitere elektrische und/oder elektronische Bauelement 60 und das erste Teilelement 30.1 in einem zu Stapelaufbau S1 artgleichen Stapelaufbau S2 angeordnet. Insbesondere sind mittels des Metallclips dabei mindestens zwei Leistungshalbleiter als Teil einer Halbbrücke miteinander verbunden. Insgesamt liegt dann ein Leistungsmodul vor mit einem Außenstromanschluss 30.2 als beispielsweise Teil einer B6-Brücke vor.

Grundsätzlich kann das zweite Teilelement 30.1 anstelle der Fügehaltevorrichtung 50 auch mittels eines dritten Fügepartners 30, beispielsweise einem Abstandshalter, in einem Abstand a zum Schaltungsträger gebracht werden. Dabei ist der Abstandhalter 30 sowohl mit dem Schaltungsträger 20 als auch mit dem zweiten Teilelement 30.2 lötverbunden. Der Versatz b ergibt sich dabei durch einen zusätzlichen Setzungsvorgang des zweiten Teilelementes 30.2 und/oder des dritten Fügepartners 30 relativ zum Setzungsvorgangs des Stapelaufbaus S1 und/oder S2.

Alternativ kann das Leistungsmodul 200 auch einen Stapelaufbau S1 innerhalb der Kontaktanordnung 100 umfassen, welcher als Wärmepfad ausgebildet ist. In diesem Falle ist der erste Fügepartner 10 beispielsweise ein Metallelement oder ein unbestücktes Keramiksubstratelement. Grundsätzlich kann das Leistungsmodul 200 auch ein Gehäuse aus einer verfestigten Umhüllungsmasse 70 umfassen, beispielsweise einer Moldmasse, aus welchem zumindest der Außenstromanschluss 30.2 herausragt.

## Patentansprüche

1. Kontaktanordnung (100) mit einem elektrischen und/oder thermischen Anschlusselement (30.1, 30.2), wobei das Anschlusselement (30.1, 30.2) zumindest einen Verbindungsbereich (41) mit einem ersten Fügepartner (10) aufweist, welcher mit dem Anschlusselement (30.1, 30.2) mittels eines verfestigten Verbindungsmittels (40) stoffverbunden ist, wobei eine Lageposition des Anschlusselementes (30.1, 30.2) relativ zum ersten Fügepartner (10) zumindest in einer Raumrichtung, insbesondere in allen drei Raumrichtungen, toleranzbehaftet mit einem Verfestigen des Verbindungsmittels (40) eingestellt ist,
**dadurch gekennzeichnet, dass**
das Anschlusselement (30.1, 30.2) aus zumindest einem ersten und einem zweiten Teilelement (30.1, 30.2) gebildet ist und das erste und das zweite Teilelement (30.1, 30.2) durch einen Spalt (31) voneinander beabstandet sind, wobei das erste Teilelemente (30.1) den Verbindungsbereich (41) umfasst und der Spalt (31) durch ein Verbindungselement (30.3) überbrückt ist, welches zum Ausgleich eines Lagepositionsversatzes (b) zwischen dem ersten und dem zweiten Teilelement (30.1, 30.2) in der zumindest toleranzbehafteten Raumrichtung mittels des gleichen oder mittels eines anderen verfestigten Verbindungsmittels (40) jeweils mit dem ersten und mit dem zweiten Teilelement (30.1, 30.2) stoffverbunden ist.

2. Kontaktanordnung (100) nach Anspruch 1,
**dadurch gekennzeichnet, dass**
der erste Fügepartner (10) auf einer dem ersten Teilelement (30.1) abgewandten Seite mit einem zweiten Fügepartner (20) mittels des verfestigten Verbindungsmittels (40) stoffverbunden ist, insbesondere einem Schaltungsträger.

3. Kontaktanordnung (100) nach einem der Ansprüche 1 oder 2,
**dadurch gekennzeichnet, dass**
das zweite Teilelement (30.2) einen zweiten Verbindungsbereich (41) zu einem dritten Fügepartner (30) aufweist, insbesondere einem Abstandshalter, welcher mit dem zweiten Teilelement (30.2) und bevorzugt mit dem zweiten Fügepartner (20) jeweils mittels des gleichen oder mittels eines anderen Verbindungsmittels (40) stoffverbunden ist, wobei eine Lageposition des zweiten Teilelementes (30.2) relativ zum ersten und/oder zweiten und/oder dritten Fügepartner (10, 20, 30) zumindest in der toleranzbehafteten Raumrichtung mit einem Verfestigen des Verbindungsmittels (40) eingestellt ist.

4. Kontaktanordnung (100) nach einem der vorhergehenden Ansprüche,
**dadurch gekennzeichnet, dass**
das Verbindungsmittel (40) ein aus einem geschmolzen Zustand verfestigtes Lotmittel ist.

5. Kontaktanordnung (100) nach Anspruch 2,
**dadurch gekennzeichnet, dass**
das zweite Teilelement (30.2) in zumindest einem Fixbereich einen fest definierten Abstand (a) in der zumindest toleranzbehafteten Raumrichtung zu dem zweiten Fügepartner (20) aufweist.

6. Kontaktanordnung (100) nach einem der vorhergehenden Ansprüche,
**dadurch gekennzeichnet, dass**
das erste Teilelement (30.1) zwischen dem Verbindungsbereich (41) mit dem ersten Fügepartner (10) und dem Stoffschluss mit dem Verbindungselement (30.3) und/oder das zweite Teilelement (30.2) zwischen dem zweiten Verbindungsbereich (41) oder dem Fixbereich (50') und dem Stoffschluss mit dem Verbindungselement (30.3) freitragend ausgebildet ist/sind.

7. Kontaktanordnung (100) nach einem der vorhergehenden Ansprüche,
**dadurch gekennzeichnet, dass**
der erste Fügepartner (10) ein elektrisches und/oder elektronisches Bauelement ist, insbesondere ein Leistungshalbleiterelement oder ein Chipelement, oder eine Wärmesenke ist, insbesondere ein Metallelement oder ein unbestücktes Keramiksubstratelement.

8. Kontaktanordnung (100) nach einem der vorhergehenden Ansprüche,
**dadurch gekennzeichnet, dass**
das erste Teilelement (30.1) ein Metallclip ist, welcher ein elektrisches und/oder elektronisches Bauelement (10) mit zumindest einem weiteren elektrischen und/oder elektronischen Bauelement (60) verbindet, insbesondere zwei Leistungshalbleiter als Teil einer Halbbrücke.

9. Kontaktanordnung (100) nach einem der vorhergehenden Ansprüche,
**dadurch gekennzeichnet, dass**
das zweite Teilelement (30.2) ein Außenstromanschluss ist, insbesondere als Teil einer B2- oder B6-Brücke.

10. Leistungsmodul (200) mit einem Außenstromanschluss (30.2), welcher zumindest als Teil einer Kontaktanordnung (100) nach einem der vorhergehenden Ansprüche mit einer Leistungsschaltung (201), insbesondere einer B2- oder B6-Brücke, ausgebildet ist.

11. Verfahren zur Ausbildung einer Kontaktanordnung (100) nach einem der Ansprüche 1 bis 9, mit den nachfolgenden Verfahrensschritten:
d) Ausbilden einer Fügeanordnung (100'), umfassend zumindest den ersten Fügepartner (10) und das erste Teilelement (30.1), wobei in einem vorgesehenen ersten Verbindungsbereich (41) zwischen dem ersten Fügepartner (10) und dem ersten Teilelement (30.1) zu diesen angrenzend ein Lotdepot (40') angeordnet wird, sowie umfassend zumindest das zweite Teilelement (30.2), welches mit einem Spalt (31) beabstandet zum ersten Teilelement (30.1) angeordnet wird, und umfassend das Verbindungselement (30.3), welches gegenüber dem ersten und dem zweiten Teilelement (30.1, 30.2) derart angeordnet wird, dass der Spalt (31) durch dieses überbrückt wird, wobei zwischen dem Verbindungselement (30.3) und den beiden Teilelementen (30.1, 30.2) zumindest in einem jeweiligen Bereich zu diesen angrenzend ein Lotdepot (40') angeordnet wird,
e) Temperaturbehandlung der Fügeanordnung (100'), durch welche das Lotdepot (40') als ein in einen geschmolzenen Zustand gebrachtes Lotmittel (40) vorliegt,
f) Verfestigen des Lotmittels (40) durch eine Temperaturabkühlung unter Ausbildung der Kontaktanordnung (100) mit einem jeweiligen Stoffschluss im Bereich eines ursprünglich angeordneten Lotdepots (40'), wobei ein Lagepositionsversatz (x) zwischen dem ersten und dem zweiten Teilelement (30.1, 30.2) aufgrund eines Absetzens des ersten Teilelementes (30.1) durch den erfolgten Lötvorgang durch das mit beiden Teilelementen (30.1, 30.2) stoffverbundene Verbindungselement (30.3) ausgeglichen wird.

12. Verfahren nach Anspruch 11,
**dadurch gekennzeichnet, dass**
das zweite Teilelement (30.2) vor der Temperaturbehandlung gemäß dem Verfahrensschritt b) in seiner Lageposition festgehalten wird, insbesondere durch eine Fügehaltevorrichtung (50).
